# EUROPÄISCHE PATENTSCHRIFT

(11) **EP 2 011 172 B1**
(45) Veröffentlichungstag und Bekanntmachung des Hinweises auf die Patenterteilung: **11.01.2012**
(21) Anmeldenummer: 07728096.4
(22) Anmeldetag: 13.04.2007
(51) Int. Cl.: H01L 43/08, H01L 43/10, G01R 33/09

(54) **ANORDNUNG MIT MAGNETORESISTIVEM EFFEKT SOWIE VERWENDUNGEN DAVON**
MAGNETORESISTIVE-EFFECT ARRANGEMENT AND USES THEREOF
ARRANGEMENT À EFFET MAGNÉTORÉSISTIF ET SES UTILISATIONS

(30) Priorität: 26.04.2006 DE 102006019482
(43) Veröffentlichungstag der Anmeldung: 07.01.2009
(73) Patentinhaber: SIEMENS AKTIENGESELLSCHAFT, 80333 München (DE)
(72) Erfinder: SARFERT, Wiebke, 91074 Herzogenaurach (DE); RIEGER, Gotthard, 91058 Erlangen (DE); RÜHRIG, Manfred, 90542 Eckental (DE); PÄTZODL, Ralph, 91154 Roth (DE); SCHMID, Günter, 91334 Hemhofen (DE); WECKER, Joachim, 91341 Röttenbach (DE); WEISS, Roland, 91058 Erlangen (DE)
(86) Internationale Anmeldenummer: PCT/EP2007/053631
(87) Internationale Veröffentlichungsnummer: WO 2007/125022

(56) Entgegenhaltungen:
- WO-A-2006/044715
- DE-A1- 10 128 135
- JP-A- 4 167 192
- JP-A- 59 139 689
- US-A1- 2003 183 915
- US-A1- 2005 062 174
- WOHLGENANNT M ET AL: "Spin and magnetic field effects in organic semiconductor devices - Spintronics" IEE PROCEEDINGS: CIRCUITS DEVICES AND SYSTEMS, INSTITUTION OF ELECTRICAL ENGINEERS, STENVENAGE, GB, Bd. 152, Nr. 4, 5. August 2005 (2005-08-05), Seiten 385-392, XP006024925 ISSN: 1350-2409
- WANTZ G ET AL: "Correlation between the Indium Tin Oxide morphology and the performances of polymer light-emitting diodes" THIN SOLID FILMS, ELSEVIER-SEQUOIA S.A. LAUSANNE, CH, Bd. 485, Nr. 1-2, 1. August 2005 (2005-08-01), Seiten 247-251, XP004962670 ISSN: 0040-6090
- GAO WEIYING ET AL: "Controlled p doping of the hole-transport molecular material N,N'-diphenyl-N,N'-bis(1-naphthyl)-1,1'-bi phenyl-4,4'-diamine with tetrafluorotetracyanoquinodimethane" JOURNAL OF APPLIED PHYSICS, AMERICAN INSTITUTE OF PHYSICS. NEW YORK, US, Bd. 94, Nr. 1, 1. Juli 2003 (2003-07-01), Seiten 359-366, XP012059656 ISSN: 0021-8979 in der Anmeldung erwähnt

## Beschreibung

Die Erfindung betrifft eine Anordnung mit magnetoresistivem Effekt, insbesondere eine mit zumindest einem elektronischen Dünnschichtbauteil. Diese werden beispielsweise als Sensoren zur Positions- und Strommessung oder zur Messung magnetischer Felder (Kompass) auf Basis magnetischer Schichtstrukturen (AMR/GMR/TMR) oder als Hallsensoren eingesetzt.

Bekannt sind Dünnschichtfolgen mit magnetoresistivem Effekt deren Empfindlichkeit gegenüber dem bei einschichtigen Systemen auftretenden klassischen "AMR" Effekt deutlich, insbesondere um mindestens eine Größenordnung erhöht ist. Hauptvertreter sind der so genannte GMR (Giant Magneto Resistance) Effekt und der TMR (Tunneling Magneto Resistance) Effekt.

Diese Effekte sind beispielsweise in dem Übersichtsartikel "Sandwiches mit riesigem Magnetwiderstand" von J. Wecker, R. Richter und R. Kinder erschienen in "Physik in unserer Zeit" 33. Jahrgang, 2002, Heft. Nr. 5, Seite 210 beschrieben.

Aus der DE 101 28 135 A1 sind konventionelle magnetoresistive Schichtanordnungen bekannt, die integrierte hartmagnetische Schichten zur Erzeugung von Biasmagnetfeldern umfassen. Als Biasmagnetschicht wird eine integrierte hartmagnetische Schicht in direktem Kontakt zu einer Weichmagnetschichtabfolge vorgeschlagen. Ferner sind allgemein magnetoresistive Effekte in organischen Halbleiterschichten in "Spin and magnetic field effects in organic semiconductor devices", M. Wohlgenannt et al., IEE Proc.- Circuits Devices Syst., Vol. 152, No. 4, August 2005, Seiten 385-392 beschrieben. Dort wird eine Anordnung von zwei ferromagnetischen Elektroden mit einem nichtmagnetischen organischen Spacer, welcher magnetoresistive Eigenschaften aufweist, dargestellt.

Die Effekte werden in vielseitig anwendbaren Anordnungen genutzt.

Nachteilig an den bisher bekannten Anordnungen ist jedoch, dass sie nur kostenintensiv herstellbar sind und überwiegend aus spröden und/oder starren Materialien gemacht sind.

Aufgabe der vorliegenden Erfindung ist es daher, eine verbesserte Dünnschicht-Anordnung mit magnetoresistivem Effekt zu schaffen, die kostengünstig, großflächig und/oder in Massenproduktion herstellbar ist und/oder biegsame oder flexible Schichten umfasst.

Lösung der Aufgabe und Gegenstand der Erfindung ist eine organisch-magnetoresistive Anordnung gemäß Anspruch 1, zumindest ein organisches elektronisches Dünnschichtbauteil mit zumindest drei Schichten auf einer oberen Seite eines flexiblen Substrats und zumindest eine magnetfelderzeugende Vorrichtung umfassend, wobei die Anordnung flexibel und derart ist, dass die magnetfelderzeugende Vorrichtung im organischen elektronischen Dünnschichtbauteil eine magnetoresistive Veränderung hervorruft, wobei ein Biasmagnet auf der anderen Seite des Substrats vorgesehen ist. Außerdem ist Gegenstand der Erfindung die Verwendung einer solchen Anordnung zur Positionsmessung bei linearen Bewegungen, Drehbewegungen, Winkelmessungen, bei der Strommessung über das vom Strom hervorgerufene Magnetfeld und/oder Messungen von Magnetfeldern (Kompass).

Diese Anordnung kann auch als OMR (Organisch magneto resistiv) bezeichnet werden. Der Biasmagnet verschiebt die Widerstandsänderungskurve (über dem Magnetfeld) hin zu einem Arbeitspunkt, bei dem die Änderungen des externen - zu messenden Feldes mit höherer Genauigkeit und annähernd linear wiedergegeben werden. Der auf der anderen Seite des Substrats angeordnete Biasmagnet ist typischerweise räumlich nahe an das Bauteil angebracht. Eine derartige Anordnung kann auch OMR-Sensor mit Stützfeld genannt werden.

Das Stützfeld kann durch einen Permanentmagneten erzeugt werden. Die Stärke des Feldes wird eingestellt über das Sensormaterial, seine Geometrie und den Abstand zum Sensor. Beispiele können preiswerte Ferritmagnete sein oder ggf. bei kleinen Baugrößen Seltenerd-Magnete (auf Basis Sm-Co oder Nd-Fe-B). Diese Materialien können auch in Form kunststoffgebundener Magnete eingesetzt werden. Stützfelder sind größer als 1 mT, vorteilhaft größer als 5 mT.

Nach einer Ausführungsform der Erfindung ist das Material der Dünnschichten so gewählt, dass die sonst bei herkömmlichen magnetoresistiven Sensoren auftretenden Hystereseeffekte möglichst unterdrückt werden.

Ein besonderer Vorteil der organischen Dünnschichten ist beispielsweise, dass die Schichten als dünne Folien aufgebracht werden können und, beispielsweise auf einem Foliensubstrat als Trägersubstanz aufgebracht, im Ganzen eine flexible und biegsame Anordnung ergeben, die auch großflächig herstellbar ist.

Neben geringen Herstellungskosten - beispielsweise kann das organische Elektronikbauteil einfach drucktechnisch, oder durch Rakeln oder Prägen hergestellt werden - liegt der Vorteil derartiger Anordnungen vor allem in den verschwindenden Hysterese-Effekten und in der hohen Isotropie - beides Merkmale die sich auf Grund der verwendeten magnetischen Materialien in gegenwärtig entwickelten Sensoren wohl nur mit sehr hohem Aufwand realisieren lassen.

Nach einer Ausführungsform ist die OMR-Anordnung als Sensor ausgebildet. Dabei ist neben dem organischen Elektronikbauteil und der Vorrichtung zur Erzeugung eines Magnetfelds eine weitere Vorrichtung vorgesehen, die die magnetoresistive Änderung im organischen Bauteil feststellt und, beispielsweise zusätzlich durch eine Auswerteelektronik verarbeitet, weiterleitet.

Nach einer vorteilhaften Ausführungsform handelt es sich um eine langzeitstabile OMR-Anordnung, beispielsweise um einen Sensor mit wenig reaktiven Elektroden, was z.B. durch den Einsatz von dotierten Transportschichten erreicht werden kann, der ausreichend stabil gegenüber Korrosion ist, was zur Folge hat, dass auf Verkapselungen verzichtet werden kann, um ein langzeitstabiles Device zu schaffen.

Nach einer weiteren Ausführungsform ist zumindest eine der Schichten des organischen Bauelements dotiert, um die Einsatzspannung und/oder die Betriebsspannung gezielt einstellen zu können.

Das organische Elektronikbauteil umfasst zumindest drei Schichten, zwei elektrisch leitfähige und eine organische Dünnschicht. Dabei ist der Begriff "Schicht" nicht eng als gesonderte Schicht auszulegen, sondern es wird auf eine Funktionalität abgestellt. So kann durchaus eine der leitfähigen Schichten durch eine Dotierung einer mittleren Schicht ersetzbar sein, wobei dann bei der Zählung der Schichten im Dünnschichtbauteil an der Stelle nur eine Schicht gezählt werden kann, von der Funktionalität her aber sind in der Schicht doch zwei Schichten enthalten.

Jede der Schichten kann mit beliebigen Dopanden versetzt sein. Gedacht ist an Versetzungen mit Dopanden und Dotierungen, wie sie beispielsweise in Applied Physics Letters 88, 152107 (2006) und in Journal of Applied Physics Vol. 94, Number 1, Seite 359 beschrieben sind.

Die organische(n) Dünnschicht(en) können entweder halbleitend, leitend oder isolierend sein. Dabei ist keiner der Begriffe streng begrenzt, sondern es gibt fließende Übergänge. Innerhalb eines organischen elektronischen Bauteils ist die Aufteilung jedoch klar, weil im Zusammenhang mit den übrigen Schichten eindeutig formuliert werden kann, welche der Schichten des organischen elektronischen Dünnschichtbauteils als halbleitend, leitend oder isolierend wirkt.

Zusätzlich kann das organische Elektronikbauteil noch andere Funktionalitäten haben, beispielsweise kann es eine selbstemittierende, eine elektrochrome und/oder eine photoaktive Schicht haben. Diese Schichten können auch beliebig mit anderen Schichten im Verbund vorliegen.

Die elektrisch leitfähigen Schichten oder eine oder alle äu-βeren Schichten des organischen Dünnschichtbauteils, insbesondere also die Elektrodenschichten, können sowohl transparent als auch nicht transparent sein.

Jede der drei Schichten kann durch beliebige Hilfsschichten ergänzt sein, ebenso kann das organische elektronische Bauteil sowohl verkapselt als auch unverkapselt vorliegen.

Es wird vorgeschlagen, je nach Ausformung und benötigter Stabilität eine Verkapselung zu applizieren, die entweder aus einer verklebten Glasscheibe/Kappe oder aus einer Folge von aufeinander gestapelten Dünnschichten besteht. Es besteht auch die Möglichkeit, mischformen der beiden Ansätze zu verwenden, z.B. eine Dünnschichtfolge, auf die ein Deckglas geklebt wird.

Gegenüber einem unverkapselten OMR Bauteil - womöglich mit einer reaktiven Kathode versehen - wird durch die erfindungsgemäße Ausformung der Applikation eine Langzeitstabilität erreicht, die den Einsatz in verschiedenen Applikationen erlaubt. Durch z.B. eine Dünnschichtverkapselung kann dabei weiterhin ein flexibles Bauteil erreicht werde. Weiterhin ist es auch möglich, das OMR Element auf biegsamem Dünnglas aufzubauen und mit demselben zu versiegeln. Ebenso gut kann die flexible Trägerfolie, auf die die Anordnung aufgebracht wurde, auf der anderen Seite wieder als Versiegelung/Verkapselung eingesetzt werden.

Bei der Positionsmessung bei linearen Bewegungen, Drehbewegungen, Winkelmessungen, bei der Strommessung über das vom Strom hervorgerufene Magnetfeld und/oder Messungen von Magnetfeldern (Kompass) hat sich die Ausführungsform der OMR-Anordnung mit einem Stützmagneten als besonders geeignet erwiesen.

Im Folgenden wird die bevorzugte Ausführungsform der Erfindung, die einen Biasmagneten umfasst, noch anhand von 6 Figuren näher erläutert:

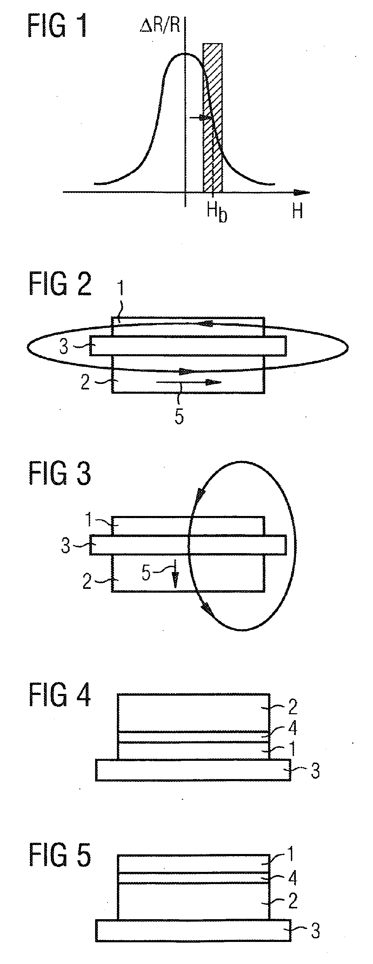

Figur 1: Abgebildet ist die prinzipielle Kennlinie mit Stützfeld Hb und dem schraffierten Arbeitsbereich. Der Widerstand R der OMR-Anordnung ändert sich unter Einwirkung eines äußeren Feldes H. Im Nullfeld (äußeres Feld = 0) können diese Kennlinien R(H) ggf. nur eine geringe Änderung bei kleinen Feldänderungen zeigen. Deshalb soll durch ein magnetisches Stützfeld der Arbeitspunkt des Sensors in den Bereich verschoben werden, in dem die Kennlinie die größte Empfindlichkeit zeigt.
Figur 2 zeigt eine erfindungsgemäße OMR-Anordnung mit Biasmagneten. Zu erkennen ist das Substrat 3, wobei auf der oberen Seite des Substrates das organisch elektronische Dünnschichtbauteil 1 zu erkennen ist und auf der anderen Seite des Substrates 3 der Stützmagnet 2 mit einer inplane Magnetisierung.
Figur 3 zeigt alternativ dazu den identischen Aufbau mit Substrat 3 mittig zwischen Dünnschichtbauteil 1 und Stützmagnet 2, allerdings mit dem Unterschied, dass der Stützmagnet 2 hier eine senkrechte Magnetisierung hat.

Das Magnetfeld wirkt entweder in Schichtebene für den Fall (Fig.2), dass auch das zu messende Feld in Schichtebene einwirkt. Wird der Sensor so betrieben, dass die Feldkomponente senkrecht zu Schichtebene gemessen werden soll, wird der Stützmagnet/-magnetschicht senkrecht aufmagnetisiert (Fig.3).

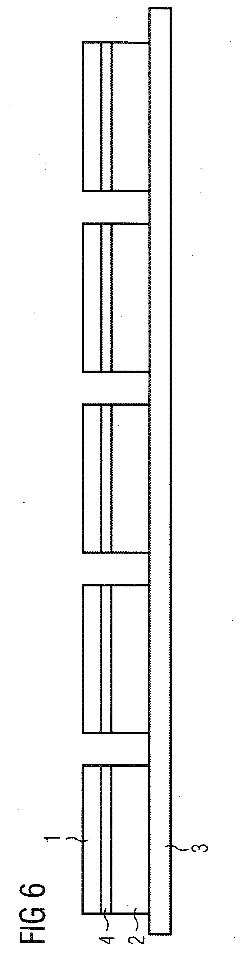

In den Figuren 4, 5 und 6 werden nicht-erfindungsgemäße Varianten mit Stützmagneten gezeigt, wobei einmal (Figur 4) ein Stützmagnet 2 oberhalb einer Isolierschicht 4 auf dem organisch elektronischen Dünnschichtbauteil 1, die ihrerseits auf dem Substrat 3 aufgebracht ist, angeordnet ist.

In Figur 5 ist der Stützmagnet zwischen dem Substrat 3 und dem organisch elektronischen Dünnschichtbauteil 1 angeordnet, wobei wieder zwischen dem organisch elektronischen Dünnschichtbauteil 1 und dem Stützmagnet eine Isolierschicht 4 liegt.

Figur 6 zeigt schließlich eine Sensormatrix mit integrierten Magnetschichten zur Erzeugung eines Biasfeldes. Der Aufbau der einzelnen Pixel der Matrix entspricht hier dem aus Figur 5.

Weitere vorteilhafte Ausführungsformen der Erfindung ergeben sich aus Kombinationen der einzelnen erfindungsgemäßen Ausführungsformen.

Das organische Elektronikbauteil basiert auf einer organischen Dünnschicht. Die organischen Elektronikbauteile in Dünnschichttechnik sind im Sinne der Erfindung nicht begrenzt.

Unter dem Begriff "organische Materialien" sollen alle Arten von organischen, metallorganischen und/oder anorganischen Kunststoffen unter Ausnahme der klassischen auf Germanium, Silizium usw. basierenden Halbleitermaterialien verstanden werden. Es ist auch möglich, gefüllte Kunststoffe und Hybridmaterialien einzusetzen. Ferner soll der Begriff "organisches Material" ebenfalls nicht auf kohlenstoffhaltiges Material beschränkt sein, vielmehr sind auch Materialien wie Silicone möglich. Weiterhin sind neben polymeren und oligomeren Substanzen auch so genannte "small molecules" verwendbar.

So kann eine funktionelle Halbleiterschicht aus organischem Material beispielsweise aus Polythiophenen, Polyalkylthiophen, Poly-Di-Hexyl-Ter-Thiophen (PDHTT), Polythienylenvinylenen, Polyfluoren-Derivaten, Polyvenylenvinylen (PPV) oder artverwandte substituierte Systeme oder anderen konjugierten Polymeren bestehen, um eine Auswahl an möglichen Substanzen zu benennen. Diese Materialien können beliebige Dotierungen haben, wobei auch nicht die ganze Schicht dotiert sein muss, sondern beispielsweise nur der an eine nächste Schicht angrenzende Bereich (Interface) dotiert sein kann.

Es können als organisches Material Blends beliebiger Polymere mit beliebigen Füllstoffen, auch leitfähigen und/oder magnetischen Füllstoffen eingesetzt werden. Auch die Füllstoffe können in beliebigen Fraktionen vorliegen und in Korngöße und Zusammensetzung beliebig variieren. Daneben oder ergänzend können auch im Polymer gebundene Magnetpulver eingesetzt werden.

Das organische Material kann dia-, para-, ferro-, antiferro- und/oder ferrimagnetisch sein. Auch LC-Materialien können eingesetzt werden, solange in ihnen durch das von außen angelegte Magnetfeld eine magnetoresistive Veränderung erzeugt werden kann.

In der Schichtabfolge des organischen Elektronikbauteils können auch eine oder mehrere Schichten für spezielle Ladungsträger vorgesehen sein, beispielsweise eine Lochtransportschicht oder eine Exzitonentransportschicht. Dabei kann auf die in der Literatur zu diesen Zwischenschichten bekannten Materialien für die Zwischenschichten zurückgegriffen werden. Beispielsweise sind die Zwischenschichten aus TAD (4,4'-bis(3-methylphenylphenylamino)-biphenyl) bekannt.

Die Schicht aus organischem Material kann, beispielsweise im Fall, dass das organische Elektronikbauteil eine selbstemittierende Schicht hat, auch ein Singulett oder Triplett emittierendes Material umfassen.

Die Schicht aus organischem Material wird nach üblichen Beschichtungsmethoden hergestellt. Beispielsweise wird sie aus Lösung durch Aufschleudern (spin-coating), Rakeln und/oder Drucken aufgebracht sein. Es können halbleitende, leitende und/oder isolierende Schichten aus organischem Material sein.

Nach einer Ausführungsform der Erfindung sind zumindest zwei organische Elektronikbauteile in Dünnschichttechnik in der Anordnung enthalten. Es können aber auch mehrere organische Elektronikbauteile übereinander gestapelt in der Anordnung enthalten sein.

Diese Stapelfolgen können z.B. durch Charge Generation Layers (CGL) oder Anode-Cathode Layer (ACL) verbunden werden, wodurch es zur Trennung von Ladungsträgern im Bauteil kommt um so in Serie geschaltete, auf einander gestapelte Bauelemente zu erhalten.

Durch die Erfindung wird erstmals eine OMR-Anordnung mit Biasmagnet, insbesondere in Dünnschichttechnik, vorgeschlagen.

Die Erfindung betrifft eine Anordnung mit magnetoresistivem Effekt, insbesondere eine mit zumindest einem elektronischen Dünnschichtbauteil. Diese werden als Sensoren zur Positions- und Strommessung oder zur Messung magnetischer Felder (Kompass) auf Basis magnetischer Schichtstrukturen (AMR/GMR/TMR) oder als Hallsensoren eingesetzt. Erfindungsgemäß wird vorgeschlagen, Sensoren, die organische Materialien vorzugsweise in Form von Schichten benutzen, einzusetzen.

## Patentansprüche

1. Organisch-magnetoresistive (OMR)-Anordnung zumindest ein organisches elektronisches Dünnschichtbauteil (1) mit zumindest drei Schichten auf einer oberen Seite eines flexiblen Substrats (3) und zumindest eine magnetfelderzeugende Vorrichtung umfassend, wobei die OMR-Anordnung flexibel und derart ist, dass die magnetfelderzeugende Vorrichtung im organischen elektronischen Dünnschichtbauteil (1) eine magnetoresistive Veränderung hervorruft,
**dadurch gekennzeichnet,**
**dass** auf der anderen Seite des Substrats (3) ein Biasmagnet (2) zum Verschieben einer Widerstandsänderungskurve des organisch elektronischen Dünnschichtbauteils (3) zu einem Arbeitspunkt vorgesehen ist.

2. OMR-Anordnung nach Anspruch 1, die als Sensor ausgebildet ist.

3. OMR-Anordnung nach einem der vorstehenden Ansprüche, wobei zumindest eine der Schichten des organischen elektronischen Dünnschichtbauteils (1) so dotiert ist, dass die Einsatzspannung und/oder die Betriebsspannung gezielt einstellbar sind.

4. OMR-Anordnung nach einem der vorstehenden Ansprüche, wobei eine oder mehrere äußere Schichten des organischen elektronischen Dünnschichtbauteils (1) transparent sind.

5. OMR-Anordnung nach einem der vorstehenden Ansprüche, wobei das organische elektronische Dünnschichtbauteil (1) verkapselt ist.

6. Verwendung einer OMR-Anordnung nach einem der vorstehenden Ansprüche zur Positionsmessung bei linearen Bewegungen, Drehbewegungen, Winkelmessungen, bei der Strommessung über das vom Strom hervorgerufene Magnetfeld und/oder Messungen von Magnetfeldern.

## Claims

1. Organic magnetoresistive (OMR) arrangement comprising at least one organic electronic thin-film component (1) having at least three layers on an upper side of a flexible substrate (3) and at least one magnetic-field-generating device, the OMR arrangement being flexible and such that the magnetic-field-generating device brings about a magnetoresistive change in the organic electronic thin-film component (1),
**characterized**
**in that** a bias magnet (2) for shifting a resistance change curve of the organic electronic thin-film component (3) to an operating point is provided on the other side of the substrate (3) .

2. OMR arrangement according to Claim 1, which is embodied as a sensor.

3. OMR arrangement according to either of the preceding claims, wherein at least one of the layers of the organic electronic thin-film component (1) is doped such that the threshold voltage and/or the operating voltage can be set in a targeted manner.

4. OMR arrangement according to any of the preceding claims, wherein one or more outer layers of the organic electronic thin-film component (1) are transparent.

5. OMR arrangement according to any of the preceding claims, wherein the organic electronic thin-film component (1) is encapsulated.

6. Use of an OMR arrangement according to any of the preceding claims for position measurement in the case of linear movements, rotary movements, angle measurements, in the case of current measurement by means of the magnetic field brought about by the current, and/or measurements of magnetic fields.

## Revendications

1. Agencement organo-magnétorésistif ( AOM ), comprenant au moins un composant ( 1 ) organique électronique à couches minces, ayant au moins trois couches sur une face supérieure d'un substrat souple et au moins un dispositif produisant un champ magnétique, l'agencement AOM étant souple et étant tel que le dispositif produisant un champ magnétique provoque une modification magnétorésistive dans le composant ( 1 ) organique électronique à couches minces,
**caractérisé**
**en ce que**, sur l'autre face du substrat ( 3 ), est prévu un aimant ( 2 ) de polarisation, pour déplacer une courbe de modification de la résistance du composant ( 3 ) organique électronique à couches minces vers un point de travail.

2. Agencement AOM suivant la revendication 1, qui est constitué en capteur.

3. Agencement AOM suivant l'une des revendications précédentes, dans lequel au moins l'une des couches du composant ( 1 ) organique électronique à couches minces est dopée, de manière à pouvoir régler à dessein la tension de coupure et/ou la tension de fonctionnement.

4. Agencement AOM suivant l'une des revendications précédentes, dans lequel une ou plusieurs couches extérieures du composant ( 1 ) organique électronique à couches minces sont transparentes.

5. Agencement AOM suivant l'une des revendications précédentes, dans lequel le composant ( 1 ) organique électronique à couches minces est encapsulé.

6. Utilisation d'un agencement AOM suivant l'une des revendications précédentes, pour la mesure de position dans des déplacements linéaires, des déplacements en rotation, des mesures angulaires, lors de la mesure du courant par le champ magnétique provoqué par le courant et/ou dans des mesures de champ magnétique.
